(19) Europäisches Patentamt
European Patent Office
Office européen des brevets

(11) Publication number: 0 148 787 A2

# (12) EUROPEAN PATENT APPLICATION

(21) Application number: 85300184.0

(22) Date of filing: 10.01.85

(51) Int. Cl.4: G 03 F 7/08

(30) Priority: 10.01.84 JP 2521/84
06.02.84 JP 18287/84

(43) Date of publication of application: 17.07.85
Bulletin 85/29

(84) Designated Contracting States: DE FR GB

(71) Applicant: JAPAN SYNTHETIC RUBBER CO., LTD.,
11-24, Tsukiji-2-chome Chuo-ku, Tokyo (JP)

(72) Inventor: Hosaka, Yoshihiro, 2-303, JSR Shataku 29,
Aobadai-2-chome, Midori-ku Yokohama (JP)
Inventor: Miura, Takao, 2-302, JSR Shataku 29,
Aobadai-2-chome, Midori-ku Yokohama (JP)
Inventor: Harita, Yoshiyuki, 1-9-6, Shirahatadai
Takatsu-Ku, Kawasaki-shi (JP)

(74) Representative: Tubby, David George et al, MARKS & CLERK 57-60 Lincoln's Inn Fields, London WC2A 3LS (GB)

## (54) Positive type photosensitive resin composition.

(57) A positive type photosensitive resin composition comprises a mixture of 100 parts by weight of an alkalisoluble resin and from 5 to 100 parts by weight of (I) at least one 1,2-quinonediazidesulfonic acid ester of a natural coloring matter selected from α-pyrone compounds having hydroxyl groups, γ-pyrone compounds having hydroxyl groups, diazine compounds having hydroxyl groups and quinone compounds having hydroxyl groups, (II) at least one 1,2-quinonediazidesulfonic acid ester of a hydroxybenzoate compound, or a combination of (I) and (II). This positive type photosensitive resin composition has a high sensitivity, a high resolution and a high yield of residual film thickness and also has excellent developability and is well suited for use as a high-resistant photoresist for making integrated circuits.

EP 0 148 787 A2

# POSITIVE TYPE PHOTOSENSITIVE RESIN COMPOSITION

This invention relates to a positive type photosensitive resin composition. More particularly, it relates to a positive type photosensitive resin composition having a high sensitivity, a high resolution and a high yield of residual film thickness and being also excellent in developability and suited for use as a heat-resistant photoresist for making integrated circuits, said composition comprising a mixture of an alkali-soluble resin and a specific 1,2-quinonediazide compound or compounds.

As the photoresists usable for making integrated circuits, there are known negative type photoresists consisting of a blend of a cyclized isoprene rubber and a bisazide compound. These negative type photoresists, however, have limits in their resolution and are therefore unable to cope with the increasing of degree of integration in integrated circuits. In comparison with such negative type photoresists, the positive type photoresists made from a blend of an alkali-soluble resin and a 1,2-quinonediazide compound (or compounds) are excellent in resolution and expected to be able to meet the increasing of degree of integration in integrated circuits.

The conventional positive type photoresists, however, had the problem that the pattern formed

therewith is susceptible to deformation by a rise of temperature in the post-baking or dry etching step. Therefore, a positive type photoresist which undergoes no such pattern deformation by a rise of temperature, that is, a positive type photoresist having excellent heat resistance, has been desired.

The object of this invention is to provide a heat-resistant positive type photosensitive resin composition which is free of said defects of the prior art and which has a high sensitivity, a high resolution and a high yield of residual film thickness and is also excellent in developability.

As a result of extensive studies for achieving said object, the present inventors have found that a positive type photosensitive resin composition consisting essentially of a blend of an alkali-soluble resin and a specific 1,2-quinonediazide compound has no said defects.

According to this invention, there is provided a positive type photosensitive resin composition consisting essentially of a mixture of 100 parts by weight of an alkali-soluble resin and 5 to 100 parts by weight of at least one 1,2-quinonediazidesulfonic acid ester selected from the following groups (I) and (II):

(I) 1,2-quinonediazidesulfonic acid esters of natural coloring matters selected from the group consistsing of α-pyrone compounds having hydroxyl groups, γ-pyrone compounds having hydroxyl groups,

diazine compounds having hydroxyl groups and quinone compounds having hydroxyl groups.

(II) 1,2-quinonediazidesulfonic acid esters of hydroxybenzoate compounds.

The 1,2-quinonediazidesulfonic acid esters of the above group (I) can be obtained by condensing a 1,2-quinonediazidesulfonyl chloride such as 1,2-naphthoquinonediazide-4-sulfonyl chloride, 1,2-naphthoquinonediazide-5-sulfonyl chloride, 1,2-benzoquinonediazide-4-sulfonyl chloride or the like, preferably 1,2-naphthoquinonediazide-5-sulfonyl chloride, with the whole or a part of the hydroxyl groups of a natural coloring matter selected from the group consisting of α-pyrone compounds having hydroxyl groups, γ-pyrone compounds having hydroxyl groups, diazine compounds having hydroxyl groups and quinone compounds having hydroxyl groups in the presence of a basic catalyst and purifying the reaction mixture.

Examples of said α-pyrone compounds having hydroxyl groups include hispidin, 2',3'-dioxy-dibenzo-α-pyrone, ellagic acid, dalbergine, oospolactone and the like. Examples of said γ-pyrone compounds having hydroxyl groups include eugenin, brazilin, haematoxylin, euxanthone, gentimin, chrysin, toringin which is a glycoside of chrysin, primetin, apigenin, apiin which is a glycoside of apigenin, luteolin, quercetin, quercitrin which is a glycoside of quercetin, isoquercitrin, quercimetrin, rutin, hyperin, galangin,

kaempferol, fisetin, morin, rhamnetin, myricetin, naringenin, naringin which is a glycoside of naringenin, sakuranetin, hesperetin, alpion, catechin, daizein, prunetin, pruitrin which is a glycoside of prunetin, irigenin, iridin which is a glycoside of irigenin, osajin, pelargonidin, cyanidine, leucodelphinidin and the like. Examples of said diazine compounds having hydroxyl groups include xanthopterin, leucopterin, entropterin, chrysopterin, iodinin and the like. Examples of said quinone compounds having hydroxyl groups include polyporic acid, atromentin, leucomelon, muscarufin, oosporein, juglone, echinochrome A, spinone A, spinochrome N, alizarin, purpurin, emodin, carminic acid, kermesic acid, skyrin, pyromycin and the like.

The proportion of 1,2-quinonediazidesulfonyl chloride used to the natural coloring matter in the condensation reaction can be properly adjusted according to the number of hydroxyl groups of said natural coloring matter; however, 1,2-quinonediazidesulfonyl chloride is usually used in a proportion of one mole per equivalent of hydroxyl group used for condensing said 1,2-quinonediazidesulfonyl chloride.

The basic catalyst used for the condensation reaction includes inorganic alkalis such as sodium hydroxide, potassium hydroxide, sodium carbonate and the like, and organic amines such as diethylamine, triethylamine and the like. Such basic catalyst is used in an amount of usually 1 to 2 moles, preferably 1 to

1.3 moles, per mole of 1,2-quinonediazidosulfonyl chloride used.

The condensation reaction is usually carried out in the presence of a solvent. As the solvent, there can be used water, dioxane, diethyl ether, tetrahydrofuran, acetone, methyl ethyl ketone and the like, in an amount of usualy 100 to 1,000 parts by weight per 100 parts by weight of the natural coloring matter.

The condensation reaction temperature may vary depending on the type of the solvent used, but usually it is in the range of from -20 to 60°C, preferably 0 to 40°C.

Examples of the 1,2-quinonediazidosulfonic acid esters thus obtained which is used in the composition of this invention include the following compounds:

hispidin-1,2-naphthoquinonediazide-5-sulfonic acid diester,

hispidin-1,2-naphthoquinonediazide-5-sulfonic acid monoester,

2',3'-dioxy-dibenzo-α-pyrone-1,2-naphthoquinonediazide-5-sulfonic acid diester,

ellagic acid-1,2-naphthoquinonediazide-5-sulfonic acid tetraester,

ellagic acid-1,2-naphthoquinonediazide-5-sulfonic acid triester,

dalbergine-1,2-naphthoquinonediazide-5-sulfonic acid monoester,

oospolactone-1,2-naphthoquinonediazide-5-sulfonic acid monoester,

eugenin-1,2-naphthoquinonediazide-5-sulfonic acid monoester,

brazilin-1,2-naphthoquinonediazide-5-sulfonic acid triester,

haematoxylin-1,2-naphthoquinonediazide-5-sulfonic acid pentaester,

haematoxylin-1,2-naphthoquinonediazide-5-sulfonic acid tetraester,

haematoxylin-1,2-naphthoquinonediazide-5-sulfonic acid triester,

haematoxylin-1,2-naphthoquinonediazide-5-sulfonic acid diester,

euxanthone-1,2-naphthoquinonediazide-5-sulfonic acid diester,

gentimin-1,2-naphthoquinonediazide-5-sulfonic acid diester,

chrysin-1,2-naphthoquinonediazide-5-sulfonic acid diester,

toringin-1,2-naphthoquinonediazide-5-sulfonic acid diester,

primetin-1,2-naphthoquinonediazide-5-sulfonic acid diester,

apigenin-1,2-naphthoquinonediazide-5-sulfonic acid triester,

apiin-1,2-naphthoquinonediazide-5-sulfonic acid triester,

luteolin-1,2-naphthoquinonediazide-5-sulfonic

acid triester,

quercetin-1,2-naphthoquinonediazide-5-sulfonic acid pentaester,

quercetin-1,2-naphthoquinonediazide-5-sulfonic acid tetraester,

quercetin-1,2-naphthoquinonediazide-5-sulfonic acid triester,

quercetin-1,2-naphthoquinonediazide-5-sulfonic acid diester,

quercetin-1,2-naphthoquinonediazide-5-sulfonic acid monoester,

quercetin-1,2-naphthoquinonediazide-4-sulfonic acid tetraester,

quercetin-1,2-benzoquinonediazide-4-sulfonic acid tetraester,

quercitrin-1,2-naphthoquinonediazide-5-sulfonic acid tetraester,

isoquercitrin-1,2-naphthoquinonediazide-5-sulfonic acid tetraester,

quercimetrin-1,2-naphthoquinonediazide-5-sulfonic acid tetraester,

rutin-1,2-naphthoquinonediazide-5-sulfonic acid diester,

hyperin-1,2-naphthoquinonediazide-5-sulfonic acid tetraester,

galangin-1,2-naphthoquinonediazide-5-sulfonic acid triester,

kaempferol-1,2-naphthoquinonediazide-5-sulfonic acid triester,

fisetin-1,2-naphthoquinonediazide-5-sulfonic acid triester,

morin-1,2-naphthoquinonediazide-5-sulfonic acid tetraester,

morin-1,2-naphthoquinonediazide-5-sulfonic acid pentaester,

rhamnetin-1,2-naphthoquinonediazide-5-sulfonic acid triester,

myricetin-1,2-naphthoquinonediazide-5-sulfonic acid pentaester,

naringenin-1,2-naphthoquinonediazide-5-sulfonic acid triester,

naringin-1,2-naphthoquinonediazide-5-sulfonic acid diester,

sakuranetin-1,2-naphthoquinonediazide-5-sulfonic acid diesters,

hesperetin-1,2-naphthoquinonediazide-5-sulfonic adid diester,

alpinon-1,2-naphthoquinonediazide-5-sulfonic acid diester,

catechin-1,2-naphthoquinonediazide-5-sulfonic acid tetraester,

daizein-1,2-naphthoquinonediazide-5-sulfonic acid monoester,

prunetin-1,2-naphthoquinonediazide-5-sulfonic

acid diester,

prunitrin-1,2-naphthoquinonediazide-5-sulfonic acid diester,

irigenin-1,2-naphthoquinonediazide-5-sulfonic acid diester,

iridin-1,2-naphthoquinonediazide-5-sulfonic acid diester,

osajin-1,2-naphthoquinonediazide-5-sulfonic acid diester,

pelargonidin-1,2-naphthoquinonediazide-5-sulfonic acid triester,

cyanidine-1,2-naphthoquinonediazide-5-sulfonic acid tetraester,

leucodelphinidin-1,2-naphthoquinonediazide-5-sulfonic acid pentaester,

xanthopterin-1,2-naphthoquinonediazide-5-sulfonic acid diester,

leucopterin-1,2-naphthoquinonediazide-5-sulfonic acid triester,

entropterin-1,2-naphthoquinonediazide-5-sulfonic acid triester,

chrysopterin-1,2-naphthoquinonediazide-5-sulfonic acid diester,

iodinin-1,2-naphthoquinonediazide-5-sulfonic acid diester,

polyporic acid-1,2-naphthoquinonediazide-5-sulfonic acid diester,

atromentin-1,2-naphthoquinonediazide-5-sulfonic

acid triester,

luecomelon-1,2-naphthoquinonediazide-5-sulfonic acid triester,

muscarufin-1,2-naphthoquinonediazide-5-sulfonic acid diester,

oosporein-1,2-naphthoquinonediazide-5-sulfonic acid triester,

juglone-1,2-naphthoquinonediazide-5-sulfonic acid monoester,

echinochrome A-1,2-naphthoquinonediazide-5-sulfonic acid tetraester,

spinone A-1,2-naphthoquinonediazide-5-sulfonic acid tetraester,

spinochrome N-1,2-naphthoquinonediazide-5-sulfonic acid triester,

alizarin-1,2-naphthoquinonediazide-5-sulfonic acid diester,

purpurin-1,2-naphthoquinonediazide-5-sulfonic acid diester,

emodin-1,2-naphthoquinonediazide-5-sulfonic acid diester,

carminic acid-1,2-naphthoquinonediazide-5-sulfonic acid triester,

kermesic acid-1,2-naphthoquinonediazide-5-sulfonic acid triester,

skyrin-1,2-naphthoquinonediazide-5-sulfonic acid hexaester, and

pyromycin-1,2-naphthoquinonediazide-5-sulfonic

acid triester.

Among these 1,2-quinonediazidosulfonic acid esters of group (I), those of natural coloring matters composed of γ-pyrone compounds having hydroxyl groups are preferred.

These 1,2-quinonediazidesulfonic acid esters can be used either singly or in combination.

The 1,2-quinonediazidesulfonic acid esters of hydroxybenzoate compounds of group (II) mentioned above are the compounds represented by the following general formulas (A) and (B):

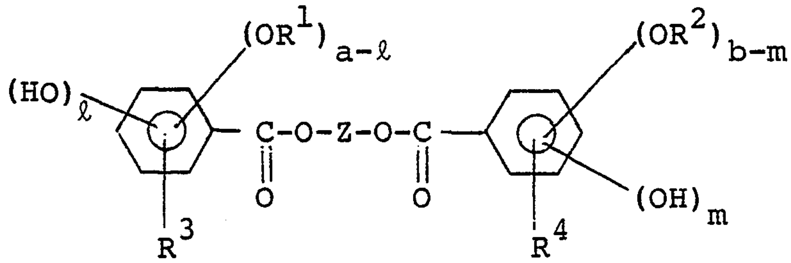

(A)

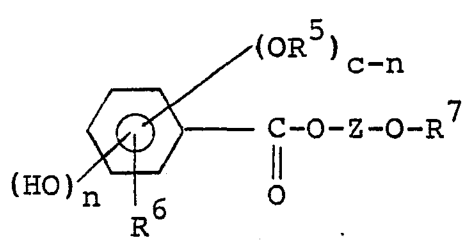

(B)

wherein a, b and c, which may be the same or different, represent integers of 1 to 4; $\ell$, m and n, which may be the same or different, are 0 or integers of 1 to 3; $(a-\ell)$,

(b-m) and (c-n) are integers of 1 or more; $R^1$, $R^2$ and $R^5$, which may be the same or different, are 1,2-naphthoquinonediazide-4-sulfonyl, 1,2-naphthoquinonediazide-5-sulfonyl or 1,2-benzoquinonediazide-4-sulfonyl groups; $R^3$, $R^4$ and $R^6$, which may be the same or different, are hydrogen atoms; halogen atoms such as chlorine, bromine, or the like; alkyl groups (preferably $C_{1-4}$alkyl groups such as methyl, ethyl, propyl or the like); aryl groups such as phenyl, naphthyl or the like; aralkyl groups such as benzyl, or the like; alkoxy groups (preferably $C_{1-3}$alkoxy groups such as methoxy or the like); aroxy groups (preferably $C_{6-9}$aroxy groups, such as phenoxy, or the like); aralkoxy groups (preferably $C_{7-10}$aralkoxy groups such as benzyloxy or the like); cyano groups; or nitro groups; $R^7$ is an alkyl group (preferably a $C_{1-4}$alkyl group such as methyl, ethyl, propyl, butyl or the like), an aryl group such as phenyl or the like, or an aralkyl group such as isopropenyl, benzyl or the like; and Z is an oxalkylene or alkylene group represented by the formula: $-[-(C_pH_{2p})]_rC_pH_{2p}-$ (wherein p is an integer of 1 to 4, and r is 0 or an integer of 1 to 100) such as ethylene glycol, propylene glycol, polyethylene glycol, polypropylene glycol, methylene, ethylene, propylene or the like).

The compounds represented by the general formulas (A) and (B), which are used as a sensitizer in the composition of this invention, can be produced,

for instance, by subjecting a hydroxybenzoate compound to condensation reaction with 1,2-quinonediazidesulfonyl chloride. More specifically, the compounds represented by the general formula (A) or (B) can be obtained by condensing a 1,2-quinonediazidesulfonyl chloride such as 1,2-naphthoquinonediazide-4-sulfonyl chloride, 1,2-naphthoquinonediazide-5-sulfonyl chloride, 1,2-benzoquinonediazide-4-sulfonyl chloride or the like, preferably 1,2-naphthoquinonediazide-5-sulfonyl chloride, with the whole or a part of the hydroxyl groups of a compound represented by the following general formula (C) or (D):

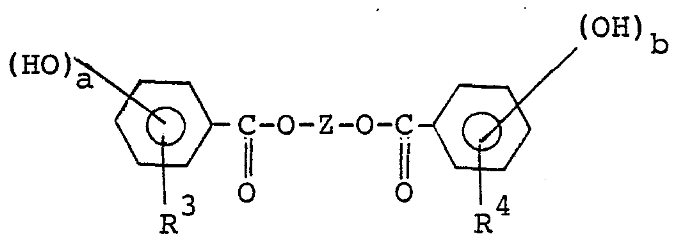

(C)

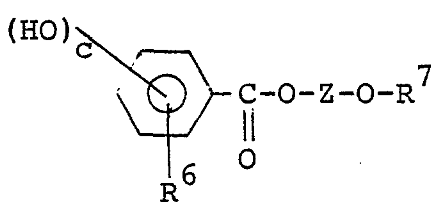

(D)

wherein a, b, c, $R^3$, $R^4$, $R^6$ and Z have the same meanings as defined as to the general formula (A) or (B), in the presence of a basic catalyst and purifying the reaction

mixture.

The proportion of 1,2-quinonediazidesulfonyl chloride to the compound represented by the general formula (C) or (D) in the above condensation reaction can be optionally adjusted according to the number of hydroxyl groups of the compound represented by the general formula (C) or (D) used for condensing 1,2-quinonediazidesulfonyl chloride; however, said 1,2-quinonediazidesulfonyl chloride is usually used in a proportion of 1 mole per equivalent of hydroxyl group.

As the basic catalyst in said condensation reaction, there may be employed the same compounds as used when synthesizing the 1,2-quinonediazide compounds of the group (I) by condensation. Also, the amount of the basic catalyst used, the type and amount of the reaction solvent used and the reaction temperature can be the same as in the case of the 1,2-quinonediazide compoudns of the group (I).

The compounds represented by the general formula (C) include, for example, ethylene glycol di(2-hydroxybenzoate), ethylene glycol di(3-hydroxybenzoate), ethylene glycol di(4-hydroxybenzoate), ethylene glycol di(2,3-dihydroxybenzoate), ethylene glycol di(2,6-dihydroxybenzoate), ethylene glycol di(3,5-dihydroxybenzoate), ethylene glycol di(3,4,5-trihydroxybenzoate), ethylene glycol di(3,4,5-trihydroxybenzoate), ethylene glycol di(2-nitro-3,4,5-trihydroxybenzoate), ethylene glycol di(2-cyano-3,4,5-trihydroxybenzoate), ethylene

glycol di(2,4,6-trihydroxybenzoate), diethylene glycol di(2,3-dihydroxybenzoate), diethylene glycol di(2-hydroxy-3-methylbenzoate), triethylene glycol di(3-hydroxy-4-methylbenzoate), tetraethylene glycol di(4-chloro-2-hydroxybenzoate), polyethylene glycol di(5-chloro-2-hydroxybenzoate), propylene glycol di(3-chloro-4-hydroxybenzoate), polypropylene glycol di(3-hydroxy-4-nitrobenzoate), polypropylene glycol di(2-hydroxy-5-methoxybenzoate), 1,3-propanediol-di(4-hydroxy-3-methoxybenzoate), 1,3-propanediol di(3,4,5-trihydroxybenzoate), 1,4-butanediol di(3-hydroxybenzoate), 1,4-butanediol di(5-bromo-2-hydroxybenzoate), polytetrahydrofuran glycol di(3,4,6-trihydroxybenzoate), neopentyl glycol di(3,4,5-trihydroxybenzoate), 1,2-benzyldimethanol di(3,4,5-trihydroxybenzoate), 1,3-benzenemethanol di(3,4,5-trihydroxybenzoate) and the like.

The compounds represented by the general formula (D) include, for example, ethylene glycol monoethyl-mono-(3,4,5-trihydroxybenzoate), ethylene glycol monoethyl-mono(3,4,5-trihydroxybenzoate), ethylene glycol monoethyl-mono(2,4,6-trihydroxybenzoate), diethylene glycol monoethyl-mono(2,3-dihydroxybenzoate), triethylene glycol monoethyl-mono(3,5-dihydroxybenzoate), ethylene glycol monophenyl-mono(3,4,5-trihydroxybenzoate) and the like.

Examples of the compounds represented by the general formula (A) obtained in the manner described above include the following:

Ethylene glycol di(2-hydroxybenzoate)-1,2-naphthoquinonediazide-4-sulfonic acid diester, ethylene glycol di(3-hydroxybenzoate)-1,2-naphthoquinonediazide-5-sulfonic acid diester, ethylene glycol di(4-hydroxybenzoate)-1,2-benzoquinonediazide-4-sulfonic acid diester, ethylene glycol di(4-hydroxybenzoate)-1,2-naphthoquinonediazide-5-sulfonic acid diester, ethylene glycol di(2,3-dihydroxybenzoate)-1,2-naphthoquinonediazide-5-sulfonic acid tetraester, ethylene glycol di(2,6-dihydroxybenzoate)-1,2-naphthoquinonediazide-5-sulfonic acid triester, ethylene glycol di(3,5-dihydroxybenzoate)-1,2-naphthoquinonediazide-5-sulfonic acid diester, ethylene glycol di(3,4,5-trihydroxybenzoate)-1,2-naphthoquinonediazide-5-sulfonic acid hexaester, ethylene glycol (2-nitro-3,4,5-trihydroxybenzoate)-1,2-naphthoquinonediazide-5-sulfonic acid hexaester, ethylene glycol (2-cyano-3,4,5-trihydroxybenzoate)-1,2-naphthoquinonediazide-5-sulfonic acid hexaester, ethylene glycol di(3,4,5-trihydroxybenzoate)-1,2-naphthoquinonediazide-5-sulfonic acid pentaester, ethylene glycol di(3,4,5-trihydroxybenzoate)-1,2-naphthoquinonediazide-5-sulfonic acid tetraester, ethylene glycol di(3,4,5-trihydroxybenzoate)-1,2-naphthoquinonediazide-5-sulfonic acid triester, ethylene glycol di(3,4,5-trihydroxybenzoate)-1,2-naphthoquinonediazide-5-sulfonic acid diester, ethylene glycol di(3,4,5-trihydroxybenzoate)-1,2-naphthoquinonediazide-5-sulfonic acid monoester, ethylene glycol di(2,4,6-trihydroxybenzoate)-1,2-naphthoquinonediazide-5-sulfonic acid pentaester, diethylene glycol di(2,3-dihydroxybenzoate)-1,2-naphthoquinonediazide-5-sulfonic

acid diester, diethylene glycol di(2-hydroxy-3-methylbenzoate)-1,2-naphthoquinonediazide-5-sulfonic acid diester, triethylene glycol di(3-hydroxy-4-methylbenzoate)-1,2-naphthoquinonediazide-5-sulfonic acid diester, tetraethylene glycol di(4-chloro-2-hydroxybenzoate)-1,2-naphthoquinonediazide-5-sulfonic acid diester, polyethylene glycol di(5-chloro-2-hydroxybenzoate)-1,2-naphthoquinonediazide-5-sulfonic acid diester, propylene glycol di(3-chloro-4-hydroxybenzoate)-1,2-naphthoquinonediazide-5-sulfonic acid diester, polypropyelne glycol di(3-hydroxy-4-nitrobenzoate)-1,2-naphthoquinonediazide-5-sulfonic acid diester, polypropylene glycol di(2-hydroxy-5-methoxybenzoate)-1,2-naphthoquinonediazide-5-sulfonic acid diester, 1,3-propanediol di(4-hydroxy-3-methoxybenzoate)-1,2-naphthoquinonediazide-5-sulfonic acid diester, 1,3-propanediol di(3,4,5-trihydroxybenzoate)-1,2-naphthoquinonediazide-5-sulfonic acid pentaester, 1,4-butanediol di(3-hydroxybenzoate)-1,2-naphthoquinonediazide-5-sulfonic acid diester, tetramethylene glycol di(5-bromo-2-hydroxybenzoate)-1,2-naphthoquinonediazide-5-sulfonic acid diester, polytetrahydroxyfuran glycol di(3,4,5-trihydroxybenzoate)-1,2-naphthoquinonediazide-5-sulfonic acid pentaester, neopenthyl glycol di(3,4,5-trihydroxybenzoate)-1,2-naphthoquinonediazide-5-sulfonic acid pentaester, and the like.

Examples of the compounds represented by the general formula (B) include the following:

Ethylene glycol monomethyl-mono(3,4,5-trihydroxybenzoate)-1,2-naphthoquinonediazide-5-sulfonic acid triester, ethylene glycol monoethyl-mono(3,4,5-trihydroxybenzoate)-1,2-naphthoquinonediazide-5-sulfonic acid triester, ethylene glycol monoethyl-mono-(2,4,6-trihydroxybenzoate)-1,2-naphthoquinonediazide-5-sulfonic acid triester, diethylene glycol monoethyl-mono(2,3-dihydroxybenzoate)-1,2-naphthoquinonediazide-5 sulfonic acid diester, triethylene glycol monoethyl-mono(3,5-dihydroxybenzoate)-1,2-naphthoquinonediazide-5-sulfonic acid diester, and ethylene glycol monophenyl-mono(3,4,5-trihydroxybenzoate)-1,2-naphthoquinonediazide-5-sulfonic acid triester.

In the composition of this invention, the compounds represented by the general formulae (A) and (B) can be used in combination.

In the composition of this invention, the alakli-soluble resin with which the 1,2-quinonediazidesulfonic acid ester is to be mixed is not critical; however, the following may be used novolak resins obtained from phenols such as phenol, cresol, xylenol, phenylphenol and the like and aldehydes such as formaldehyde, paraformaldehyde, furfural, acetaldehyde, benzaldehyde and the like; hydroxystyrene polymers; amino-styrene polymers; and copolymers of monoolefin compounds and ethylenic unsaturated carboxylic acids.

The amount of said 1,2-quinonediazidesulfonic acid ester blended in the composition of this invention

is 5 to 100 parts by weight, preferably 10 to 50 parts by weight, per 100 parts by weight of the alkali-soluble resin. If said amount is less than 5 parts by weight, the resulting composition becomes poor in resolution, unsatisfactory in yield of residual film thickness after development and also low in heat resistance, and hence, the obtained pattern becomes susceptible to thermal deformation. On the other hand, if said amount exceeds 100 parts by weight, no high-sensitivity composition is obtained.

In the composition of this invention, other 1,2-quinonediazide compounds than the 1,2-quinonediazidesulfonic acid esters may be blended in an amount of not more than 100 parts by weight, preferably not more than 50 parts by weight, per 100 parts by weight of the alkali-soluble resin. Examples of said other 1,2-quinonediazide compounds are the compounds obtained by reacting (condensing) 1,2-naphthoquinonediazide-4-sulfonyl chloride, 1,2-naphthoquinonediazide-5-sulfonyl chloride, 1,2-benzoquinonediazide-4-sulfonyl chloride or the like with the whole or a part of the hydroxyl groups of a compound represented by the general formula (E):

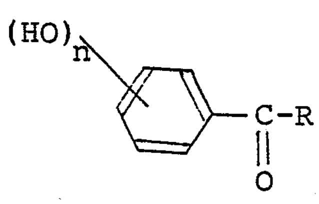

(E)

wherein n is an integer of 1 to 3, and R is an alkyl, aryl or aralkyl group.

Further, in order to improve the developability, storage stability and other properties of the composition, the composition of this invention may be blended with a natural resin such as rosin, shellac or the like or a synthetic resin such as a styrene-maleic anhydride copolymer, a copolymer of styrene and acrylic acid, methacrylic acid or an alkyl acrylate or methacrylate, acrylic ester polymer, vinylacetal polymer, vinyl ether polymer, vinyl acetate polymer, vinyl alcohol polymer, vinyl pyrrolidone polymer or the like in an amount of 1 to 50 parts by weight, preferably 5 to 30 parts by weight, per 100 parts by weight of the alkali-soluble resin.

The composition of this invention can be coated on a substrate to be finely processed, then irradiated with active light such as ultraviolet light and subjected to a developing treatment to form a pattern.

Coating of the composition of this invention on a substrate can be accomplished, for instance, by a method which comprises dissolving the composition in a solvent to a concentration of 5 to 50% by weight and coating the solution on the substrate by rotary coating, flow-coating, roll coating or other means. Solvents usable for this purpose include ketones such as cyclopentanone, cyclohexanone, diacetone alcohol

and the like; alcohols such as n-butanol and the like; ethers such as dioxane, ethylene glycol dimethyl ether, ethylene glycol diethyl ether and the like; alcohol ethers such as ethylene glycol monomethyl ether, ethylene glycol monoethyl ether and the like; esters such as butyl acetate, Cellosolve acetate, methoxyethyl acetate and the like; halogenated hydrocarbons such as 1,1,2-trichloroethylene and the like; and other polar solvents such as dimethylacetamide, dimethylsulfoxide, dimethylformamide, N-methylpyrrolidone and the like. These solvents may be used either singly or in combination. It is also possible to mix a high-boiling solvent such as benzyl ethyl ether, diethylene glycol monomethyl ether, acetonylacetone, caproic acid, 1-octanol, benzyl alcohol, propylene carbonate or the like.

A storage stabilizer, a dye and the like may optionally be added to the composition of this invention. Also, for improving the adhesion between the composition of this invention and the substrate, to the composition may be added a suitable adhering agent such as hexamethyldisilazane, chloromethylsilane or the like which is selected depending upon the type of the substrate used.

As the developer used for the development of the composition of this invention, there may be employed, for instance, aqueous solutions of inorganic alkalis such as sodium hydroxide, potassium hydroxide, sodium

carbonate, sodium silicate, sodium metasilicate, trisodium phosphate, sodium hydrogenphosphate and the like; aqueous solutions of amines such as n-propylamine, di-n-propylamine, di-n-butylamine, methyldiethylamine, pyrrole, 2,5-dimethylpyrrole, β-picolin, collidine, piperidine, piperazine, triethylenediamine and the like; aqueous solutions of alcohol amines such as dimethylethanolamine, triethanolamine, diethylhydroxyamine and the like; aqueous solutions of quaternary ammonium salts such as tetramethylammonium hydroxide, tetraethylammonium hydroxide and the like; aqueous ammonia, and the like.

An alcohol such as methanol, ethanol or the like, a sulfite type stabilizer or a surfactant may be added in a proper quantity to said developer.

The composition of this invention can be stored in the form of a solution without causing crystal precipitation of the 1,2-quinonediazide compound in the composition. The composition of this invention has a high sensitivity, a high resolution and a high yield of residual film thickness and is also excellent in developability, and it is especially useful as a positive type photoresist for the production of integrated circuits. The composition is also useful as a positive type photoresist for the manufacture of photomasks.

The present invention will be described in further detail below referring to Examples, but it

should not be interpreted that the invention be limited to the Examples.

Example 1

(1) Synthesis of novolak resin

Into a 500-ml, three-necked, separable flask were charged 75 g of m-cresol and 25 g of p-cresol, followed by the addition of 66 ml of a 37% by weight aqueous solution of formaldehyde and 0.04 g of oxalic acid. The separable flask was dipped in an oil bath and the mixture therein was subjected to reaction for 10 hours with stirring while keeping the mixture at 100°C. After the reaction, water was distilled removed by distillation at a reduced pressure of 30 mmHg, and the internal temperature was then raised to 130°C to distil off the unreacted material. Thereafter, the internal temperature was returned to room temperature and the molten alkali-soluble novolak resin, the reaction product, was recovered.

(2) Synthesis of sensitizer

Into a 2-litre, three-necked, separable flask where charged 15.11 g of morin, 67.17 g of 1,2-naphthoquinonediazide-5-sulfonyl chloride and 800 ml of dioxane while shielding light. To this solution was gradually added 30.36 g of triethylamine with stirring and the resulting mixture was subjected to reaction at room temperature for 2 hours. After the reaction, the mixture was added dropwise into a large

amount of a 1% by weight aqueous solution of hydrochloric acid to precipitate the reaction product, which was then separated, washed with water and then dried in vacuo at 40°C for 20 hours to obtain morin-1,2-naphthoquinonediazide-5-sulfonic acid pentaester (hereinafter referred to as "Sensitizer A").

(3) Preparation and evaluation of photosensitive resin composition

While shielding light, 20 g of the alkali-soluble novolak resin obtained in (1) above and 5 g of Sensitizer A obtained in (2) above were dissolved in 75 g of dimethylformamide, and the solution was filtered through a membrane filter having a pore diameter of 0.2 μm to prepare a solution of a photosensitive resin composition.

This solution was applied on a silicon oxide film wafer by a spinner and prebaked in an oven at 90°C for 25 minutes to form a 1-μm thick film of photosensitive resin composition. A test pattern mask was attached to the wafer and the film was exposed to ultraviolet rays having an intensity of 11.6 $mJ/cm^2$ (measured by a power meter Model 205UV made by Optical Associate Inc.) through said mask and then developed with a 2.0% by weight aqueous solution of tetramethylammonium hydroxide at 20°C for 60 seconds, whereby a pattern having a line width of 1.0 μm could be resolved. This indicates the excellent sensitivity and resolving power of the photosensitive resin composition of this

invention. The yield of residual film thickness at the unexposed portion was so high as 91%. Moreover, substantially no undeveloped portion remained, the formed pattern was sharp, and the developability of the composition was excellent. Also, when the developed pattern was post-baked in an oven at 175°C for 30 minutes, the pattern underwent no collapse or deformation and showed high heat resistance.

Examples 2 - 8

(1) Synthesis of sensitizer

Sensitizers were synthesized by subjecting the natural coloring matters shown in Table 1 below and 1,2-quinonediazidesulfonyl chloride to condensation reaction in the same way as in Example 1-(2).

Table 1

| Example No. | Natural coloring matter | | Amount of 1,2-naphthoquinone-diazide-5-sulfonyl chloride (g) | Produced sensitizer |
|---|---|---|---|---|
| | Kind | Amount (g) | | |
| 2 | Quercetin | 15.11 | 53.74 | Quercetin-1,2-naphthoquinonedi-azide-5-sulfonic acid tetra-ester (Sensitizer B) |
| 3 | Quercetin | 15.11 | 40.30 | Quercetin-1,2-naphthoquinonedi-azide-5-sulfonic acid triester (Sensitizer C) |
| 4 | Rutin | 30.53 | 26.87 | Rutin-1,2-naphthoquinonedizide-5-sulfonic acid diester (Sensitizer D) |
| 5 | Morin | 15.11 | 67.17 | Morin-1,2-naphthoquinonediazide-5-sulfonic acid pentaester (Sensitizer E) |
| 6 | Morin | 15.11 | 53.74 | Morin-1,2-naphthoquinonediazide-5-sulfonic acid tetraester (Sensitizer F) |
| 7 | Naringenin | 13.61 | 40.30 | Naringenin-1,2-naphthoquinonedi-azide-5-sulfonic acid triester (Sensitizer G) |
| 8 | Haematoxylin | 15.11 | 53.74 | Haematoxylin-1,2-naphthoquinone-diazide-5-sulfonic acid tetra-ester (Sensitizer H) |

(2) Preparation and evaluation of photosensitive resin composition

Solutions of photosensitive resin compositions were prepared and evaluated in the same way as in Example 1-(3) using 20 g of the alkali-soluble novolak resin obtained in Example 1-(1), 5 g of the sensitizers shown in Table 2 and 75 g of dimethyl sulfoxide. The results are shown in Table 2. It is seen from Table 2 that the photosensitive resin compositions according to this invention are excellent in sensitivity, resolution and yield of residual film thickness. Also, each of these photosensitive resin compositions has excellent developability and heat resistance like that of Example 1.

Table 2

| Example No. | Sensitizer | Amount of ultraviolet irradiated ($mJ/cm^2$) | Resolution (μm) | Yield of residual film thickness (%) |
|---|---|---|---|---|
| 2 | B | 12.6 | 1 | 92 |
| 3 | C | 11.6 | 1 | 90 |
| 4 | D | 14.7 | 1 | 90 |
| 5 | E | 10.5 | 1 | 91 |
| 6 | F | 12.6 | 1 | 90 |
| 7 | G | 13.7 | 1 | 92 |
| 8 | H | 12.6 | 1 | 90 |

1 Example 9

(1) Synthesis of sensitizer

Into a 500-ml, three-necked flask were charged 56.4 g of gallic acid and 6.2 g of ethylene glycol, followed by the addition of 150 ml of dioxane, 150 ml of benzene and 5 ml of concentrated sulfuric acid to the resulting mixture. The flask was dipped in an oil bath and the mixture therein was subjected to reaction for 20 hours at an oil bath temperature of 120°C. The produced water was removed from the reaction system through a water separator. After the reaction, iced water was poured into the reaction system and the produced ethylene glycol di(3,4,5-trihydroxybenzoate) was precipitated at a temperature close to 0°C, filtered, washed with water repeatedly and purified.

Into a 500-ml, three-necked, separable flask were charged 11.0 g of this ethylene glycol di(3,4,5-trihydroxybenzoate), 24.2 g of 1,2-naphthoquinonediazide-5-sulfonyl chloride and 200 ml of acetone while shielding light. To this solution was gradually added 10.9 g of triethylamine with stirring, and the resulting mixture was subjected to reaction at room temperature for one hour. The reaction mixture was added dropwise to a large amount of a 1% by weight aqueous hydrochloric acid solution to precipitate the reaction product, which was then separated, washed with water and dried in vacuo at 40°C for 20 hours to obtain ethylene glycol di(3,4,5-trihydroxybenzoate)-1,2-naphthoquinonediazide-5-sulfonic acid triester (hereinafter referred to as Sensitizer I).

(2) Preparation and evaluation of photosensitive resin composition

In 75 g of Cellosolve acetate were dissolved 20 g of alkali-soluble novolak resin of Example 1-(1) and 5 g of Sensitizer I obtained in (1) above, and the mixed solution was filtered through a membrane filter having a pore diameter of 0.2 μm to prepare a photosensitive resin composition solution.

This solution was applied on a silicon oxide film wafer by a spinner and prebaked in an oven at 90°C for 25 minutes to obtain a 1.2-μm thick film of photosensitive resin composition. The film was irradiated with ultraviolet rays of 18.9 $mJ/cm^2$ through a test pattern mask and then developed with a 1.6% by weight aqueous solution of tetramethylammonium hydroxide at 20°C for 60 seconds, whereby a pattern having a line width of 0.5 μm could be resolved. The yield of residual film thickness at the unexposed portion was so high as 98.8%. Also, no undeveloped portion remained, and the pattern was sharp and showed excellent developability. When the developed pattern was post-baked in an oven at 170°C for 30 minutes, no collapse or deformation of the pattern was observed.

Examples 10-14

(1) Synthesis of sensitizers

The following sensitizers J-N were synthesized in the same way as in Example 9-(1):

Sensitizer J: 1,3-propanediol di(3,4,5-trihydroxybenzoate)-1,2-naphthoquinonediazide-5-sulfonic acid tetraester which is the reaction product of 11.4 g of 1,3-propanediol di(3,4,5-trihydroxybenzoate) with 32.2 g of 1,2-naphthoquinonediazide-5-sulfonyl chloride.

Sensitizer K: diethylene glycol di(2,3-dihydroxybenzoate)-1,2-naphthoquinonediazide-5-sulfonic acid triester which is the reaction product of 11.3 g of diethylene glycol di(2,3-dihydroxybenzoate) with 24.2 g of 1,2-naphthoquinonediazide-5-sulfonyl chloride.

Sensitizer L: 1,4-butanediol di(3-hydroxybenzoate)-1,2-naphthoquinonediazide-5-sulfonic acid diester which is the reaction product of 13.2 g of 1,4-butanediol di(3-hydroxybenzoate) with 21.5 g of 1,2-naphthoquinonediazide-5-sulfonyl chloride.

Sensitizer M: ethylene glycol di(4-hydroxybenzoate)-1,2-naphthoquinonediazide-5-sulfonic acid diester which is the reaction product of 9.1 g of ethylene glycol di(4-hydroxybenzoate) with 16.1 g of 1,2-naphthoquinonediazide-5-sulfonyl chloride.

Sensitizer N: ethylene glycol monoethyl-mono(3,4,5-trihydroxybenzoate)-1,2-naphthoquinonediazide-5-sulfonic acid triester which is the reaction product of 9.7 g of ethylene glycol monoethyl-mono(3,4,5-trihydroxy-benzoate) with 35.5 g of 1,2-naphthoquinonediazide-5-sulfonyl chloride.

(2) Preparation and evaluation of photosensitive resin compositions

Photosensitive resin composition solutions were prepared in the same manner as in Example 9-(2) using 20 g of alkali-soluble novolak resin of Example 1-(1) and 5 g of Sensitizers J-N. Using these solutions, the respective photosensitive resin compositions were evaluated in the same way as in Example 9-(2). The results are shown in Table 3.

Table 3

| Example No. | Sensitizer | Resolution (μm) | Amount of ultraviolet rays irradiated (mJ/cm2) | Yield of residual film thickness (%) |
|---|---|---|---|---|
| 10 | J | 0.5 | 10.5 | 89.0 |
| 11 | K | 1.0 | 14.7 | 90.0 |
| 12 | L | 0.5 | 16.8 | 93.9 |
| 13 | M | 1.0 | 13.7 | 90.5 |
| 14 | N | 1.0 | 14.7 | 87.0 |

As seen from Table 3, the photosensitive resin compositions according to this invention had a high sensitivity, a high resolution and a high yield of residual film thickness and were also excellent in developability.

Post-baking of the developed patterns in an oven at 170°C for 30 minutes caused no collapse or deformation of the patterns in all the Examples.

Examples 15 to 18

Photosensitive resin composition solutions were prepared in the same manner as in Example 1-(3) using 20 g of the alkali-soluble novolak resin obtained in Example 1-(1) and substituting the sensitizers and solvents shown in Table 4 for the Sensitizer A and the solvent used in Example 1-(3), respectively. In the same manner as in Example 1, the photosensitive resin compositions were evaluated, to find that there were obtained sharp patterns with a high sensitivities, high resolutions and high yields of residual film thickness and without undeveloped portion.

The developed pattern was post-baked at 170°C for 30 minutes in an oven. No collaps or deformation of the patterns was observed.

Table 4

| Example No. | Sensitizer | | Solvent | | TMA*1) conc. | Reso-lution | Amount of ultra-violet rays ir-radiated | Yield of residual film thickness |
|---|---|---|---|---|---|---|---|---|
| | Kind | Amount (g) | Kind | Amount (g) | (wt.%) | (μm) | ($mj/cm^2$) | (%) |
| 15 | Sensitizer A<br>Sensitizer I | 2.5<br>2.5 | Dimethyl-formamide | 75 | 2.0 | 1 | 10.8 | 90.5 |
| 16 | Sensitizer I<br>Sensitizer N | 3.5<br>2.5 | Collosolve acetate | 75 | 1.8 | 1 | 15.3 | 95.0 |
| 17 | Sensitizer A<br>Sensitizer M*2) | 3.5<br>2.0 | Dimethyl-formamide | 75 | 2.0 | 1 | 14.3 | 91.3 |
| 18 | Sensitizer I<br>Sensitizer P*3) | 2.5<br>2.5 | Celloaolve acetate | 75 | 1.8 | 1 | 16.2 | 92.4 |

Note: 1) TMA = aqueous tetramethylammonium hydroxide solution

2) M = 2,3,4-Trihydroxybenzophenone-1,2-naphthoquinonediazide-5-sulfonic acid triester

3) P = Di(2,3,4-trihydroxyphenyl)methane-1,2-naphthoquinonediazide-5-sulfonic acid pentaester

1 Example 19 to 21

Alkali-soluble novolak resins were synthesized in the same manner as in Example 1-(1), except that the monomer or monomers shown in Table 5 were substituted for the 75 g of m-cresol and the 25 g of p-cresol. In the same manner as in Example 1-(3), photosensitive resin composition solutions were prepared using each of the novolak resins obtained and evaluated to find that all the photosensitive resin compositions had a high sensitivity, a high resolution and a high yield of residual film thickness and a sharp pattern having no undeveloped portion was obtained. The developed pattern was post-baked at 170°C for 30 minutes in an oven. No collaps or deformation of the pattern was observed.

Table 5

| Example No. | Monomer | | TMA conc. (wt.%) | Resolusion (μm) | Amount of ultra-violet rays irradiated ($mJ/cm^2$) | Yield of residual film thickness (%) |
|---|---|---|---|---|---|---|
| | Kind | Amount (g) | | | | |
| 19 | m-cresol | 100 | 1.0 | 1 | 9.5 | 92.0 |
| 20 | m-cresol<br>p-cresol<br>o-cresol | 60<br>20<br>20 | 2.3 | 1 | 11.0 | 93.5 |
| 21 | m-cresol<br>p-cresol<br>phenol | 50<br>30<br>17 | 2.1 | 1 | 11.5 | 89.7 |

CLAIMS

1. A positive type photosensitive resin composition comprising a mixture of 100 parts by weight of an alkali-soluble resin and from 5 to 100 parts by weight of at least one 1,2-quinonediazidesulfonic acid ester (I) and/or (II):

(I) 1,2-quinonediazidesulfonic acid esters of natural coloring matters selected from the group consisting of α-pyrone compounds having hydroxyl groups, γ-pyrone compounds having hydroxyl groups, diazine compounds having hydroxyl groups and quinone compounds having hydroxyl groups, and

(II) 1,2-quinonediazidesulfonic acid esters of hydroxybenzoate compounds.

2. A composition according to Claim 1, wherein the alkali-soluble resin is a novolak resin, a hydroxystyrenic resin, an aminostyrenic resin or a monoolefin-ethylenic unsaturated carboxylic acid copolymer.

3. A composition according to Claim 1, wherein the alkali-soluble resin is a novolak resin.

4. A composition according to any one of Claims 1 to 3, wherein the 1,2-quinonediazidesulfonic acid ester (I) is hispidin-1,2-naphthoquinonediazide-5-sulfonic acid diester, hispidin-1,2-naphthoquinonediazide-5-sulfonic acid monoester, 2',3'-dioxy-dibenzo-α-pyrone-1,2-naphthoquinonediazide-5-sulfonic acid diester, ellagic acid-1,2-naphthoquinonediazide-5-sulfonic acid tetraester, ellagic acid-1,2-naphthoquinonediazide-5-sulfonic acid triester, dalbergin-1,2-naphthoquinonediazide-5-sulfonic acid monoester, oospolactone-1,2-naphthoquinonediazide-5-sulfonic acid monoester, eugenin-1,2-naphthoquinonediazide-5-sulfonic acid monoester, brazilin-1,2-naphthoquinonediazide-5-sulfonic acid triester, haematoxylin-1,2-naphthoquinonediazide-5-sulfonic acid pentaester, haematoxylin-1,2-naphthoquinonediazide-5-sulfonic acid tetraester, haematoxylin-1,2-naphthoquinonediazide-5-sulfonic acid triester, haematoxylin-1,2-naphthoquinonediazide-5-sulfonic acid diester, euxanthone-1,2-naphthoquinonediazide-5-sulfonic acid diester, gentimin-1,2-naphthoquinonediazide-5-sulfonic acid diester, chrysin-1,2-naphthoquinonediazide-5-sulfonic acid diester, toringin-1,2-naphthoquinonediazide-5-sulfonic acid diester, primetin-1,2-naphthoquinonediazide-5-sulfonic acid diester, apigenin-1,2-naphthoquinonediazide-5-sulfonic acid triester, apiin-1,2-naphthoquinonediazide-5-sulfonic acid triester, luteolin-1,2-naphthoquinonediazide-5-sulfonic acid triester, quercetin-1,2-naphthoquinonediazide-5-sulfonic acid pentaester, quercetin-1,2-naphthoquinonediazide-5-sulfonic acid tetraester, quercetin-1,2-naphthoquinonediazide-5-sulfonic acid triester, quercetin-1,2-naphthoquinonediazide-5-sulfonic acid diester, quercetin-1,2-naphthoquinonediazide-5-sulfonic acid monoester, quercetin-1,2-naphthoquinonediazide-4-sulfonic acid tetraester, quercetin-1,2-benzoquinonediazide-4-sulfonic acid tetraester, quercitrin-1,2-naphthoquinonediazide-5-sulfonic acid tetraester, isoquercitrin-1,2-naphthoquinonediazide-5-sulfonic acid tetraester, quercimetrin-1,2-naphthoquinonediazide-5-sulfonic acid tetraester, rutin-1,2-naphthoquinonediazide-5-sulfonic acid diester, hyperin-1,2-naphthoquinonediazide-5-sulfonic acid tetraester, galangin-1,2-naphthoquinonediazide-5-sulfonic acid triester, kaempferol-1,2-naphthoquinonediazide-5-sulfonic acid triester, fisetin-1,2-naphthoquinonediazide-5-sulfonic acid triester, morin-1,2-naphthoquinonediazide-5-sulfonic acid tetraester, morin-1,2-naphthoquinonediazide-5-sulfonic acid pentaester, rhamnetin-1,2-naphthoquinonediazide-5-sulfonic acid triester, myricetin-1,2-naphthoquinonediazide-5-sulfonic acid pentaester, naringenin-1,2-naphthoquinonediazide-5-sulfonic acid triester, naringin-1,2-naphthoquinonediazide-5-sulfonic acid diester, sakuranetin-1,2-naphthoquinonediazide-5-sulfonic acid diester, hesperetin-1,2-naphthoquinonediazide-5-sulfonic acid diester, alpinon-1,2-naphthoquinonediazide-5-sulfonic acid diester, catechin-1,2-naphthoquinonediazide-5-sulfonic acid tetraester, daizein-1,2-naphthoquinonediazide-5-sulfonic acid monoester, prunetin-1,2-naphthoquinonediazide-5-sulfonic acid diester, prunitrin-1,2-naphthoquinonediazide-5-sulfonic acid diester, irigenin-1,2-naphthoquinonediazide-5-sulfonic acid diester, iridin-1,2-naphthoquinonediazide-5-sulfonic acid diester, osajin-1,2-naphthoquinonediazide-5-sulfonic acid diester, pelargonidin-1,2-naphthoquinonediazide-5-sulfonic acid triester, cyanidin-1,2-naphthoquinonediazide-5-sulfonic acid tetraester, leucodelphinidin-1,2-naphthoquinonediazide-5-sulfonic acid pentaester, xanthopterin-1,2-naphtoquinonediazide-5-sulfonic acid diester, leucopterin-1,2-naphthoquinonediazide-5-sulfonic acid triester, entropterin-1,2-naphthoquinonediazide-5-sulfonic acid triester, chrysopterin-1,2-naphthoquinonediazide-5-sulfonic acid diester, iodinin-1,2-naphthoquinonediazide-5-sulfonic acid diester, polyporic acid-1,2-naphthoquinonediazide-5-sulfonic acid diester, atromentin-1,2-naphthoquinonediazide-5-sulfonic acid triester, leucomelon-1,2-naphthoquinonediazide-5-sulfonic acid triester, muscarufin-1,2-naphthoquinonediazide-5-sulfonic acid diester, oosporein-1,2-naphthoquinonediazide-5-sulfonic acid triester, juglone-1,2-naphthoquinonediazide-5-sulfonic acid monoester, echinochrome A-1,2-naphthoquinonediazide-5-sulfonic acid tetraester, spinone A-1,2-naphthoquinonediazide-5-sulfonic acid tetraester, spinochrome N-1,2-naphthoquinonediazide-5-sulfonic acid triester, alizarin-1,2-naphthoquinonediazide-5-sulfonic acid diester, purpurin-1,2-naphthoquinonediazide-5-sulfonic acid diester, emodin-1,2-naphthoquinonediazide-5-sulfonic acid diester, carminic acid-1,2-naphthoquinonediazide-5-sulfonic acid triester, kermesic acid-1,2-naphthoquinonediazide-5-sulfonic acid triester, skyrin-1,2-naphthoquinonediazide-5-sulfonic acid hexaester, or pyromycin-1,2-naphthoquinonediazide-5-sulfonic acid triester.

5. A composition according to any one of Claims 1 to 3, wherein the 1,2-quinonediazidesulfonic acid ester (I) is a 1,2-quinonediazidesulfonic acid ester of a γ-pyrone compound having hydroxyl groups.

6. A composition according to any one of Claims 1 to 3, wherein the 1,2-quinonediazidesulfonic acid esters of hydroxybenzoate compounds are the compounds represented by the formula (A) and/or (B):

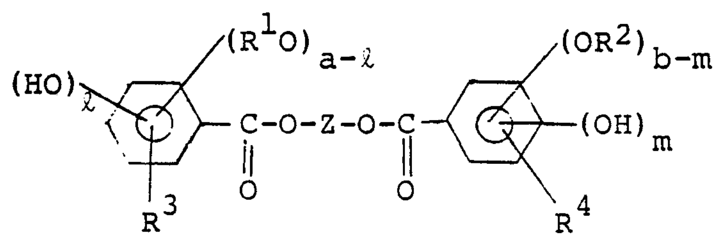

(A)

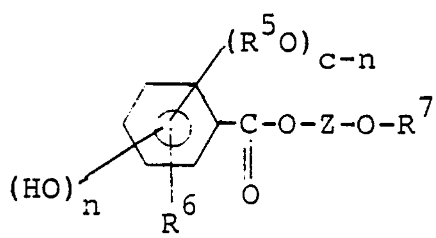

(B)

wherein a, b and c, which may be the same or different, each represents 1, 2, 3 or 4, $\ell$, m and n, which may be the same or different, each represents 0, 1, 2 or 3, $(a-\ell)$, (b-m) and (c-n) are integers of 1 or more, $R^1$, $R^2$ and $R^5$, which may be the same or different, each represents a 1,2-naphthoquinonediazide-4-sulfonyl group, 1,2-naphthoquinonediazide-5-sulfonyl group or 1,2-benzoquinonediazide-4-sulfonyl group, $R^3$, $R^4$ and $R^6$, which may be the same or different, each represents a hydrogen atom, a halogen atom, an alkyl group,

an aryl group, an aralkyl group, an alkoxy group, an aroxy group, an aralkoxy group, a cyano group or a nitro group, $R^7$ represents an alkyl group, an aryl group or an aralkyl group, and Z is an oxalkylene or alkylene group represented by the formula: $-[-(C_pH_{2p})O]_r C_pH_{2p}-$ (wherein p is 1, 2, 3 or 4, and r is 0 or an integer of 1 to 100).

7. A composition according to Claim 6, wherein the compound represented by formula (A) is ethylene glycol di(2-hydroxybenzoate)-1,2-naphthoquinonediazide-4-sulfonic acid diester, ethylene glycol di(3-hydroxybenzoate)-1,2-naphthoquinonediazide-5-sulfonic acid diester, ethylene glycol di(4-hydroxybenzoate)-1,2-benzoquinonediazide-4-sulfonic acid diester, ethylene glycol di(4-hydroxybenzoate)-1,2-naphthoquinonediazide-5-sulfonic acid diester, ethylene glycol di(2,3-dihydroxybenzoate)-1,2-naphthoquinonediazide-5-sulfonic acid tetraester, ethylene glycol di(2,6-dihydroxybenzoate)-1,2-naphthoquinonediazide-5-sulfonic acid triester, ethylene glycol di(3,5-dihydroxybenzoate)-1,2-naphthoquinonediazide-5-sulfonic acid diester, ethylene glycol di(3,4,5-trihydroxybenzoate)-1,2-naphthoquinonediazide-5-sulfonic acid hexaester, ethylene glycol (2-nitro-3,4,5-trihydroxybenzoate)-1,2-naphthoquinonediazide-5-sulfonic acid hexaester, ethylene glycol (2-cyano-3,4,5-trihydroxybenzoate)-1,2-naphthoquinonediazide-5-sulfonic acid hexaester, ethylene glycol di(3,4,5-trihydroxy-

benzoate)-1,2-naphthoquinonediazide-5-sulfonic acid pentaester, ethylene glycol di(3,4,5-trihydroxybenzoate)-1,2-naphthoquinonediazide-5-sulfonic acid tetraester, ethylene glycol di(3,4,5-trihydroxybenzoate)-1,2-naphthoquinonediazide-5-sulfonic acid triester, ethylene glycol di(3,4,5-trihydroxybenzoate)-1,2-naphthoquinonediazide-5-sulfonic acid diester, ethylene glycol di(3,4,5-trihydroxybenzoate)-1,2-naphthoquinonediazide-5-sulfonic acid monoester, ethylene glycol di(2,4,6-trihydroxybenzoate)-1,2-naphthoquinonediazide-5-sulfonic acid pentaester, diethylene glycol di(2,3-dihydroxybenzoate)-1,2-naphthoquinonediazide-5-sulfonic acid diester, diethylene glycol di(2-hydroxy-3-methylbenzoate)-1,2-naphthoquinonediazide-5-sulfonic acid diester, triethylene glycol di(3-hydroxy-4-methylbenzoate)-1,2-naphthoquinonediazide-5-sulfonic acid diester, tetraethylene glycol di(4-chloro-2-hydroxybenzoate)-1,2-naphthoquinonediazide-5-sulfonic acid diester, polyethylene glycol di(5-chloro-2-hydroxybenzoate)-1,2-naphthoquinonediazide-5-sulfonic acid diester, propylene glycol di(3-chloro-4-hydroxybenzoate)-1,2-naphthoquinonediazide-5-sulfonic acid diester, polypropyelne glycol di(3-hydroxy-4-nitrobenzoate)-1,2-naphthoquinonediazide-5-sulfonic acid diester, polypropylene glycol di(2-hydroxy-5-methoxybenzoate)-1,2-naphthoquinonediazide-5-sulfonic acid diester, 1,3-propanediol di(4-hydroxy-3-methoxybenzoate)-1,2-naphthoquinonediazide-5-sulfonic acid diester,

1,3-propanediol di(3,4,5-trihydroxybenzoate)-1,2-naphthoquinonediazide-5-sulfonic acid pentaester, 1,4-butanediol di(3-hydroxybenzoate)-1,2-naphthoquinonediazide-5-sulfonic acid diester, tetramethylene glycol di(5-bromo-2-hydroxybenzoate)-1,2-naphthoquinonediazide-5-sulfonic acid diester, polytetrahydrofuran glycol di(3,4,5-trihydroxybenzoate)-1,2-naphthoquinonediazide-5-sulfonic acid pentaester, or neopentyl glycol di(3,4,5-trihydroxybenzoate)-1,2-naphthoquinonediazide-5-sulfonic acid pentaester.

8. A composition according to Claim 6, wherein the compound represented by formula (B) is ethylene glycol monomethyl-mono(3,4,5-trihydroxybenzoate)-1,2-naphthoquinonediazide-5-sulfonic acid triester, ethylene glycol monoethyl-mono(3,4,5-trihydroxybenzoate)-1,2-naphthoquinonediazide-5-sulfonic acid triester, ethylene glycol monoethyl-mono(2,4,6-trihydroxybenzoate)-1,2-naphthoquinonediazide-5-sulfonic acid triester, diethylene glycol monoethyl-mono(2,3-dihydroxybenzoate)-1,2-naphthoquinonediazide-5-sulfonic acid diester, triethylene glycol monoethyl-mono(3,5-dihydroxybenzoate)-1,2-naphthoquinonediazide-5-sulfonic acid diester, or ethylene glycol monophenyl-mono(3,4,5-trihydroxybenzoate)-1,2-naphthoquinonediazide-5-sulfonic acid triester.

9. A composition according to any one of Claims 1 to 8, wherein the amount of the 1,2-quinonediazidesulfonic acid ester is from 10 to 50 parts by weight.

10. A composition according to any one of Claims 1 to 9, which further comprises a condensation reaction product of a compound represented by the formula (E):

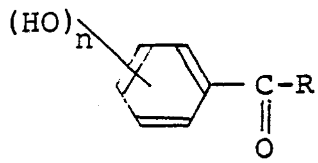

(E)

wherein n is 1, 2 or 3, and R is an alkyl group, an aryl group or an aralkyl group, with 1,2-naphthoquinonediazide-4-sulfonyl chloride, 1,2-naphtoquinonediazide-5-sulfonyl chloride or 1,2-naphthoquinonediazide-4-sulfonyl chloride in an amount of not more than 100 parts by weight per 100 parts by weight of the alkali-soluble resin.